Europäisches Patentamt

European Patent Office

Office européen des brevets

(11) Publication number: **0 331 486**
**A2**

# (12) EUROPEAN PATENT APPLICATION

(21) Application number: **89302078.4**

(51) Int. Cl.⁴: **H 01 Q 1/24**

(22) Date of filing: **02.03.89**

(30) Priority: **03.03.88 GB 8805063**

(43) Date of publication of application:
**06.09.89 Bulletin 89/36**

(84) Designated Contracting States:
**AT BE CH DE ES FR GB GR IT LI LU NL SE**

(71) Applicant: **Shaye Communications Limited**
**Capital House 48-52 Andover Road**
**Winchester, Hampshire SO23 7BH (GB)**

(72) Inventor: **Beesley, Graham Edgar**
**Upcott Cottage Church Lane Sparsholt**
**Winchester Hampshire, SO21 2NJ (GB)**

(74) Representative: **Boydell, John Christopher et al**
**Stevens, Hewlett & Perkins 5 Quality Court Chancery Lane**
**London, WC2A 1HZ (GB)**

(54) Aerials.

(57) Electronic circuitry incorporating an aerial is built upon a printed circuit board (3/4) whose metallisation acts as the radiating element of the aerial. In the particular form shown, the printed circuit board forms a folded dipole aerial with a gap (9) in the metallisation forming a feed point for the aerial. The components (13) of the circuitry are mounted within the enclosure formed by the printed circuit board, and are thus shielded by the metallisation.

FIG.2

EP 0 331 486 A2

## Description

## AERIALS

This invention relates to aerials and in particular to the implementation of an aerial and other circuitry in compact form.

In portable electronic apparatus, particularly that designed to be hand held, physical size and shape are important constraints in the design. Particular difficulty is experienced in achieving a compact and neat construction when an aerial is involved, particularly where the aerial has to be used for transmitting and is therefore subject to size constraints. Some designs utilise telescopic rod aerials which protrude from the apparatus and are inconvenient, particularly in hand-held apparatus. Other designs build the aerial into the casing occupied by the electronics which usually results in a bulky casing and the threat of undesirable interaction between the aerial and the circuit components.

In the invention, the printed circuit board which is used to mount and interconnect the components is itself used as the aerial. The metallisation which is used to interconnect the components acts as the radiator and provided that the metallisation is reasonably continuous, it will be seen by the aerial frequency as a continuous conductor, and will operate as such despite in reality having the usual gaps to allow the relatively low frequency circuit currents to flow. The two sets of currents - the high frequency aerial current, and the low frequency circuit currents - are further separated by the fact that, due to skin effect, the aerial currents tend to flow on the outside surface of the metallisation, whereas the low frequency currents use the whole cross section.

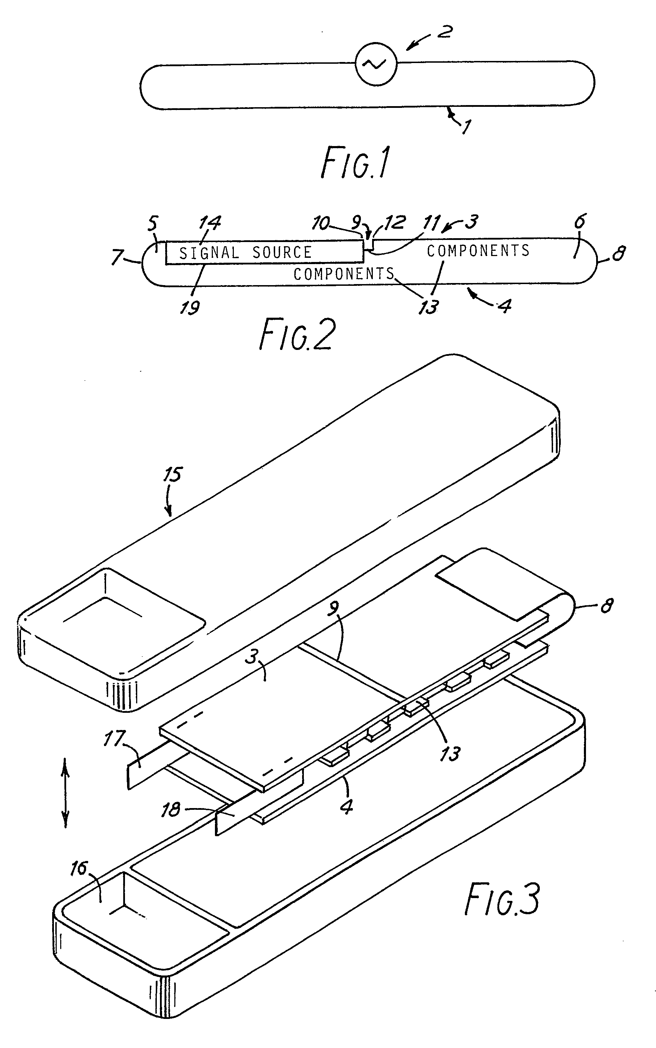

Using the technique of the invention, various types of aerial can be realised. However, particular benefit is obtained with the folded dipole aerial, a schematic drawing of which is given in Figure 1 of the accompanying drawings. The conventional folded dipole is evolved from the standard half wave dipole by adding a close coupled half wave parasitic element 1 which is voltage fed at the ends of the driven dipole 2. This parasitic element is not driven but is continuous and effectively is shorted dipole. The result of this short is to raise the driven dipoles impedance by some factor dependent on dimensional ratios but typically four.

In the invention the folded dipole aerial is made by positioning two printed circuit boards parallel with one another and electrically interconnecting the metallisation at opposite ends. The metallisation on each board thus forms one of the dipoles of the folded dipole. A gap is formed across the metallisation of one of the boards to thereby electrically break the loop formed by the metallisation of the two boards and the interconnected ends, and this gap forms the feed point for the aerial. The metallisation of said one of the boards thus becomes the driven element of the dipole while the metallisation of the other board becomes the parasitic element. Preferably the two boards are of approximately the same size, and the gap is formed approximately in the centre (i.e. midway between the interconnected ends) of said one of the boards.

This application of a folded dipole uses the continuity of the aerial loop to allow non-radiating circuitry to be placed around its perimeter. Non-radiation is achieved for this circuitry by the close proximity of the flow and return current paths which effectively cancels any alternating magnetic field created by the alternating current flows and nullifies the potential radiation. This is not the case for the current introduced across the dipole gap. This current has to flow to the ends of the dipole (quarter wave flow distance) before it returns either back down the driven element or along the parasitic element. This long uncancelled flow path results in radiation in the form of a transverse electromagnetic field, i.e. inverse square law radiation.

It is thus possible to have non-radiating circuitry around the perimeter of an efficient radiator which is itself fed by the output from the non-radiating circuitry. As already mentioned, the aerial currents generally take the outermost path but in any case can flow along a multi-path route including capacitive gaps of appropriate impedance. The aerial feed current is generated by the circuits on the boards and is applied across the gap in the dipole. Here offset feed gaps produce impedance changes but no effect on the dipole radiation.

It is possible that only partial cancellation of unintended radiation may be achieved simply by means of the proximity of flow and return current paths (i.e. deviation from transmission line structures) and additional screening to reduce this radiation may be required. This can be achieved here by two mechanisms which do not affect the radiation from the folded dipole. Firstly the circuits can be constructed on double sided printed circuit board with a substantial ground plane outermost providing microstrip transmission line characteristics and single sided screening due to the short distance of penetration of the evanescent waves through the ground plane conductor. Secondly, overall screening cans can be used to produce a double ground plane stripline structure provided only that the gap between the two radiating paths of the folded dipole is not shorted or reduced to an unacceptably low impedance. This gap dimension and the width of the dipole conducting path modifies the dipole impedance.

By judicious use of transmission line or other circuit techniques all classes of signals can be passed from one point on the boards to any other point by following the folded dipole path and leaving a defined gap along its length between the boards. The feed gap itself can be bridged at frequencies somewhat distant from the radiation frequency provided precautions are taken to cross the gap leaving only a substantially lossless and compensatable reactance at the radiation frequency, for example by passing such signals through a trap circuit comprising a parallel rejection circuit at the aerial frequency.

In order that the invention may be better understood, one embodiment thereof will now be described by way of example only and with reference to the accompanying drawings in which:-

Figure 1 is a schematic view of a folded dipole;

Figure 2 is a diagrammatic side view of a folded dipole constructed in accordance with the invention; and

Figure 3 is an exploded perspective view of an instrument casing containing a folded dipole aerial constructed in accordance with the present invention associated with electronic circuitry.

Referring to Figure 2, there is shown a folded dipole aerial comprising a first printed circuit board 3 and a second printed circuit board 4 placed parallel with one another and fairly close together so as to reproduce the electrical characteristics of the folded dipole aerial. Note that for the purpose of clarity, only the metallisation is shown. At the adjacent ends 5,6 of the circuit boards, the metallisation is joined by interconnection pieces 7,8 to provide a continuous loop. This loop is broken by forming a gap 9 in the metallisation of board 3, which gap forms the feedpoint for the aerial.

Electronic components in circuitry 13 associated with the aerial are mounted on the circuit boards 3,4 and are interconnected by the metallisation in the usual way. The low frequency currents associated with the operation of these components will not affect the ability of the metallisation to simultaneously act as an aerial element. Circuitry may be provided on one or both circuit boards.

The circuit boards 3,4 are oriented in such a way that the metallisation faces outwardly, and the components are therefore mounted on the inwardly facing surface so as to be screened by the metallisation. As already mentioned an enhanced performance may be obtained by using double sided printed circuit board, in which the metallisation on one side, the outwardly facing side, is used as a ground plane.

Where the aerial is to be used for transmitting, the components for a signal source 14 may likewise be mounted on the circuit boards of the aerial. In this case, the components are mounted on board 3 adjacent the gap 9 so that the signals generated may be applied across the gap. The signal side of the signal source output is applied to the immediately adjacent side 10 of the gap. The earth side is carried over the gap by means of a connection 11 for application to the other side 12 of the gap. In order to avoid effectively shorting the gap at aerial frequencies, and thus rendering the aerial ineffective, this connection 11 should be the only connection taken direct from the metallisation on one side of the gap to that on the other. Other connections across the gap should be avoided, where possible, but if essential should be trapped at the aerial frequency as they pass across the gap.

Figure 3 illustrates a small hand held transceiver intended to operate at frequencies around 900 MHz and incorporating the folded dipole aerial of the invention. The aerial and associated circuitry are housed in a two-part container 15 having a battery compartment 16. The aerial is formed of a rectangular printed circuit boards 3,4 with a transverse gap 11 cut in the metallisation of board 3 in the manner described above. The metallisation of the boards is interconnected at one end by a bowed connector 8 as before and at the other end by a pair of space connection pieces 17,18 which extend into the battery compartment to enable the battery connections to be affected. Note that the fact that connection pieces 17,18 are not electrically interconnected at DC and low frequencies does not reduce their effectiveness in joining the metallisation of the two boards at aerial frequencies since, at such frequencies, the metallisation of the board will be seen as substantially continuous. Clearly, some care needs to be taken in designing the layout of the metallisation to ensure that large areas without metallisation are avoided, since these may alter, possibly adversely, the performance of the aerial; however, this will not normally cause a problem.

The size of the aerial is, as is well known, dictated by the intended frequency of operation. However with the arrangement illustrated a half-wave folded dipole and associated circuitry can be implemented in a casing only a few centimeters long at 900 MHz. It will be seen that, as well as providing an efficient aerial for transmitting and/or receiving purposes, the arrangement of the invention enables equipment requiring an aerial to be constructed in a particularly compact form. Furthermore, the components comprising the circuitry associated with the aerial may be effectively screened, although in some circumstances additional screening may be desirable, such as round the signal source, as illustrated by the screening case 19 in Figure 2.

## Claims

1. Electronic circuitry incorporating an aerial, said circuitry comprising a plurality of components interconnected by metallisation on a printed circuit board and wherein the aerial is comprised of said printed circuit board.

2. Electronic circuitry as claimed in Claim 1 wherein the aerial terminals within the circuitry are connected in such a way that the metallisation acts as the radiating element of said aerial.

3. Electronic circuitry as claimed in Claim 2 wherein the aerial is a dipole aerial.

4. Electronic circuitry as claimed in Claim 3 wherein the aerial is a folded dipole aerial formed as two approximately parallel sections of printed circuit board interconnected by metallisation at the opposite ends.

5. Electronic circuitry as claimed in Claim 4 wherein a gap is formed across the metallisation of one of the printed circuit board sections to thereby electrically break the loop formed by the metallisation of the two sections and the interconnected ends in such a way that said gap forms a feed point for the aerial.

6. Electronic circuitry as claimed in Claim 5 wherein the aerial terminals comprise the metallisation or part thereof immediately adjacent said gap.

7. Electronic circuitry as claimed in either one of Claims 5 or 6 wherein said gap is formed in the approximate geometric centre of said one of the printed circuit board sections.

8. Electronic circuitry as claimed in any one of Claims 4 to 7 wherein the metallisation is positioned, at least in part, on the outwardly facing surface or surfaces of the printed circuit board making up the aerial, and wherein the components are mounted on the opposite side of the printed circuit board from the metallisation - i.e. the inside side - so as to be screened by the metallisation.

9. A transceiver comprising electronic circuitry incorporating an aerial as claimed in any one of Claims 4 to 9 wherein said aerial acts as both transmitting and receiving aerial for said transceiver.

FIG.1

| SIGNAL SOURCE | COMPONENTS |

COMPONENTS

FIG.2

FIG.3